# EUROPEAN PATENT SPECIFICATION

(11) **EP 3 849 082 B1**
(45) Date of publication and mention of the grant of the patent: **16.08.2023**
(21) Application number: 20151287.8
(22) Date of filing: 10.01.2020
(51) Int. Cl.: H03K 17/06, H03K 17/16

(54) **CLAMP CIRCUIT FOR POWER SWITCHES**
KLEMMSCHALTUNG FÜR LEISTUNGSSCHALTER
CIRCUIT DE SERRAGE POUR COMMUTATEURS DE PUISSANCE

(43) Date of publication of application: 14.07.2021
(73) Proprietor: Power Integrations Switzerland GmbH, 2504 Biel-Bienne (CH)
(72) Inventor: Garcia, Olivier, 2555 Brügg (CH); Kroll, Peter, 2504 Biel-Bienne (CH)
(74) Representative: Fish & Richardson P.C.

(56) References cited:
- EP-A2- 2 020 748
- US-A1- 2018 115 148

## Description

### BACKGROUND OF THE INVENTION

### 1. Field of the Invention

The present invention relates generally to clamping circuits for power switches, for example, power switches such as IGBTs, MOSFETs or silicon carbide MOSFETs in high power installations.

### 2. Background

Semiconductor power switches such as IGBTs are used in a variety of high power applications, including, e.g., power conversion, power generation, and power transmission. Power switches are specifically designed to survive the high power conditions in such applications. For example, power switches are designed to withstand relatively large potential differences between the main terminals (e.g., drain-to-source or collector-to-emitter voltages) in the OFF state and to conduct relatively large currents (e.g., drain or collector currents) in the ON state while dissipating relatively low power.

However, even when power switches have device characteristics that are relatively favorable, individual power switches are often incapable of meeting the demands of some applications. To address such demands, multiple power switches may be connected and switched in parallel. A given potential difference can be placed across the main terminals of the power switches, which are driven between ON and OFF states nearly synchronously to conduct a net current that is larger than the current rating of the individual switches.

One class of power switches that has relatively favorable device characteristics is insulated-gate bipolar transistors (IGBTs). IGBTs are three terminal semiconductor devices that generally include four regions of semiconductor material with alternating conductivity types. For example, IGBTs can include an n-type emitter region, a p-type body, an n-type drift region, and a p-type emitter injection region. The three terminals of an IGBT are typically known as gate, emitter, and collector. Current conduction between the collector and emitter of an IGBT is controlled by an insulated gate structure, generally, a metal-oxide-semiconductor (MOS) gate. The gate can thus be referred to as the control terminal of the IGBT, whereas the emitter and collector can be referred to as the main terminals.

IGBTs can generally provide relatively small forward conduction voltage drops and large current-carrying capability in combination with the high input impedance of an insulated gate. Multiple or single IGBT switches are often assembled into IGBT modules that are controlled using a single input terminal. At this time, IGBTs are commonly used in commercial applications to switch voltages in excess of up to 6500V and currents in excess of up to 3600A per module. IGBTs have been used in various applications, such as wind and solar power generation, high voltage direct current (HVDC) transmission systems, inductive heating and welding, transportation (e.g., electric vehicles and trains), consumer and industrial applications.

EP 2020748 (A2) describes a clamping switch that has a node connected with a switching input. A resistance element is provided with an activation input. The resistance element is guided from node to reference potential. The resistance element has a resistance value in non-activated condition and has another high resistance in the activated condition.

US 2018/0115148 describes a method for operating a gate driver circuit. The method includes supplying power to the gate driver circuit from a power supply including a positive power supply voltage and a negative power supply voltage, comparing the negative power supply voltage with a first voltage at an output terminal of a transistor, wherein the gate driver circuit is coupled to a gate terminal of the transistor, operating the gate driver circuit when the negative power supply voltage is more negative than a trigger voltage, wherein the trigger voltage is a predetermined voltage above the first voltage, and deactivating at least a portion of the gate driver circuit when the negative power supply voltage is more positive than the trigger voltage.

### BRIEF DESCRIPTION OF THE DRAWINGS

Non-limiting and non-exhaustive embodiments of the present invention are described with reference to the following figures, wherein like reference numerals refer to like parts throughout the various views unless otherwise specified.
FIG. 1 is a schematic representation of a system in which multiple power switches are connected and switched in parallel.
FIG. 2A and 2B are schematic representations of a power switch and command and driver circuitries of a power converter in which a control terminal of the power switch is clamped using reversible voltage clamp circuitry.
FIG. 3 is a timing diagram that represents, over time, various voltages of voltage clamp circuit in a power converter.
FIG. 4 is a schematic representation of a gate driver in which the control terminal of a power switch in a power converter is clamped using voltage clamp circuitry coupled with a load reduction circuit.
FIG. 5 is a schematic representation of a particular implementation of voltage clamp circuitry and load reduction circuitry.
FIG. 6 is a schematic representation of an implementation of two parallel connected inverters that are coupled to a load.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention.

### DETAILED DESCRIPTION

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

Although the current conducted by multiple power switches connected in parallel may be higher than the current rating of the individual power switches, it would be beneficial to flexibly disable current conduction through one or more of the power switches. For example, a particular power switch may be damaged or have operational characteristics that deviate from specifications to an extent sufficient to justify disablement. As another example, the power demand of an application may vary in time. Maintaining every power switch in operation at all times may reduce efficiency and/or the net lifetime of the power switches.

By way of example, inverter modules can include IGBT power switches or MOSFET power switches that are used for high power conversion applications. Each module may include a gate driver that drives switching of one or more of the transistors in the module. The gate drivers may themselves be controlled by a common (generally, external) controller to coordinate switching of the transistors in the different modules. In common terminology, both the transistors and the inverter modules can be described as "connected in parallel."

Gate drivers generally drive IGBTs or other power switches into both the ON and the OFF states. For example, in the context of an n-channel IGBT device, a gate driver will generally apply both:
- a positive voltage between the gate and the emitter to drive the IGBT into a conductive ON state; and
- a negative voltage between the gate and the emitter to drive the IGBT into an essentially non-conductive OFF state.
For example, a gate driver may couple such a gate to a relatively higher potential and thus "pull-up" the gate at least during a turn-on transition and couple the gate to a relatively lower potential and thus "pull-down" the gate at least during a turn-off transition. Further, such gate drivers commonly maintain the coupling between the gate and the respective potentials even after the turn-on/turn-off transitions have ended.

However, the coupling between the gate and the respective potentials may not be maintained in all circumstances. For example, a power supply or other component may be defective and the bias potential may not be applied or even available for application.

A defect is not necessarily required. Instead, it may be desirable for an operator to intentionally stop biasing the gate of one power switch that is both coupled in parallel with others and that is to remain in the OFF state. An example of such a circumstances can arise, e.g., in the context of an inverter module (and its associated power switch or switches). An inverter module may be intentionally disabled, e.g., when the inverter module is not working properly or simply when less power is required. Although an inverter module (and its associated power switch or switches) can be intentionally disabled, a main terminal of the power switch can remain connected to the main terminals of the other active power switches.

As discussed further below, switching events of the other, active power switches can generate signals at the control terminal of power switches in which couplings between the control terminals and potentials that drive the power switches into the OFF state are not maintained. In some circumstances, such signals may be sufficient to produce undesirable conduction through the power switch.

In order to reduce or avoid such undesirable conduction, a clamp circuit as described herein can prevent the control terminal of a power switch that is in the OFF state from crossing a threshold level and switching into conduction even if the gate driver circuit is unpowered. The clamp circuit must however allow the power switch to be driven into conduction by a drive circuit when desired, e.g., when more power is required and the formerly-disabled power switch is to conduct current in parallel with the other power switches. In other words, the clamping must be reversible such that the power switch can be intentionally switched into conduction when desired but does not inadvertently switch into conduction-even if the control terminal is not actively biased into the OFF state.

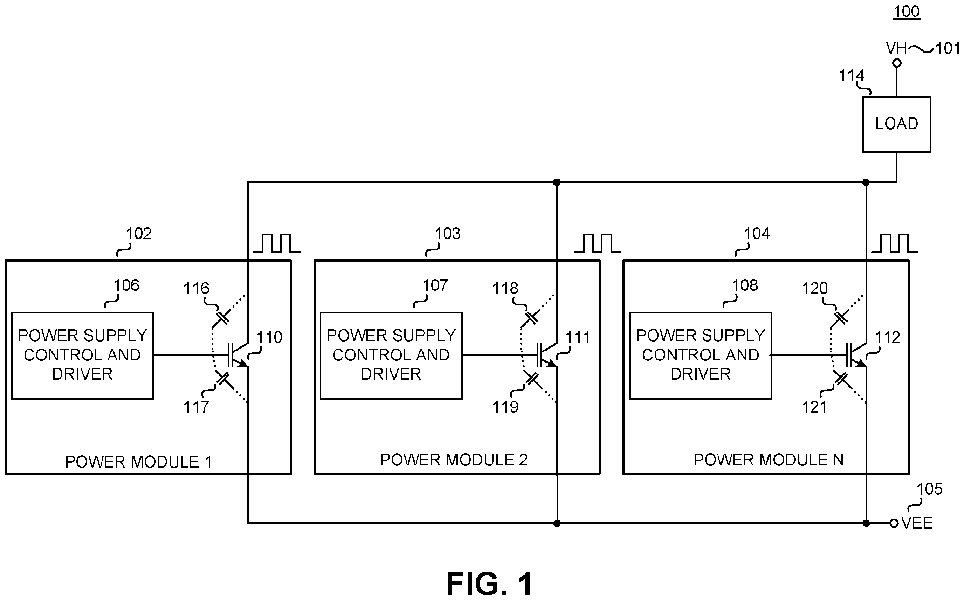

FIG. 1 is a schematic representation of a system 100 in which multiple power switches 110, 111, 112 are connected and switched in parallel. In the illustrated implementation, power switches 110, 111, 112 are each included in a respective power module 102, 103, 104 and can be switched in coordination to conduct current between high potential V_{H} 101 and low potential V_{EE} 105 through a load 114. In some cases, power switches are 110, 111, 112 are switched nearly synchronously and approximate a single low side switch that can switch a net current that exceeds the current rating of the individual power switches 110, 111, 112. Higher power can thus be delivered to load 114.

Each power module 102, 103, 104 includes respective power supply control and drive circuitry 106, 107, 108. Control and drive circuitry 106, 107, 108 receive a command signal (not shown) and output a gate drive signal to a respective gate of power switches in response to the command signal. In some implementations, the command signal can be output from a driver interface module that provides an interface between the power module and a system controller. Such a system controller can coordinate the output of the gate drive signals in the power modules 102, 103, 104 to control power switches 110, 111, 112. In general, such a driver interface module and system controller will be galvanically isolated from control and drive circuitry 106, 107, 108 and power switches 110, 111, 112. Thus, the command signal will be transmitted over a galvanically-isolated communications channel.

In real world devices, parasitic capacitances exist between the gate and emitter (i.e., parasitic capacitances 117, 119, 121) and between the collector and gate (i.e., parasitic capacitances 116, 118, 120) of power switches 110, 111, 112. As discussed further below, parasitic capacitances 117, 119, 121, 116, 118, 120 can act as a capacitive voltage divider and bias a power switch to conduct current between the main terminals when the control terminal is not coupled to a potential that maintains it in the OFF state. The decoupling may be unintentional and may arise, e.g., due to a failure in the power module itself, a defect in a voltage supply, or other inadvertence. The decoupling may also be intentional. For example, when a power module is not working properly or when less power is required, it may be desirable to decouple the control terminal of a power switch from a potential that maintains it in the OFF state. Indeed, a system may by design include redundant power modules that can be brought on-line, e.g., in the event of a failure of another power module or a change in the operational requirements.

An illustrative example in the context of system 100 would involve an inadvertent or intentional decoupling of the control terminal of power switch 112 in power module 104 from a biasing potential while the power switches in power modules 102, 103 remain on-line and actively switching. Even when the control terminal of power switch 112 is decoupled, the main terminals of power switch 112 remain coupled to the main terminals of power switches 110, 111. Power switch 112 is thus still subject to the changes in voltage and current associated with switching events at the active power switches. As noted above, these switching events can involve relatively high voltages and large currents that are switched over relatively short times.

If power is no longer supplied to the driver and the control terminal of power switch 112 is decoupled from a bias, power switch 112 is not actively switching and current conduction by parasitic capacitances 121, 120 (and by other parasitics) can lead to a potential difference between the gate and emitter of power switch 112. If this potential difference rises sufficiently high, power switch 112 will begin to conduct current between its main terminals. This current is undesirable for several reasons and will generally at least reduce the efficiency of system 100. In some cases, power switch 112 may remain in a conductive state for too long and may heat to harmful temperatures.

Although a potential difference between the gate and emitter is undesirable when power is no longer supplied to the driver and the control terminal of power switch 112 is decoupled, it must be possible to bias the gate relative to the emitter when power switch 112 is actively switching during normal operations. In particular, control and drive circuitry 108 must be able to apply a potential difference between the gate and emitter to drive power switch 112 into a conductive ON state and then to remove the potential difference to switch power switch 112 into a non-conductive OFF state. A voltage clamp like a Zener diode that prevents a large potential difference from arising between the gate and emitter of power switch 112 is thus inadequate to meet the needs of both enabling the power switch when desired and ensuring that the power switch remains in the OFF state when the control terminal is decoupled from a biasing potential.

Instead, described herein is voltage clamp circuitry that reversibly clamps the voltage between the control terminal and the main terminal to a voltage level. The clamping is reversible in that it is removed during times when the power switch is actively switching during normal operations (e.g., the control and driver circuitries are powered) but can be present when the control terminal of a power switch is decoupled from a biasing potential (e.g., the control and driver circuitries are unpowered).

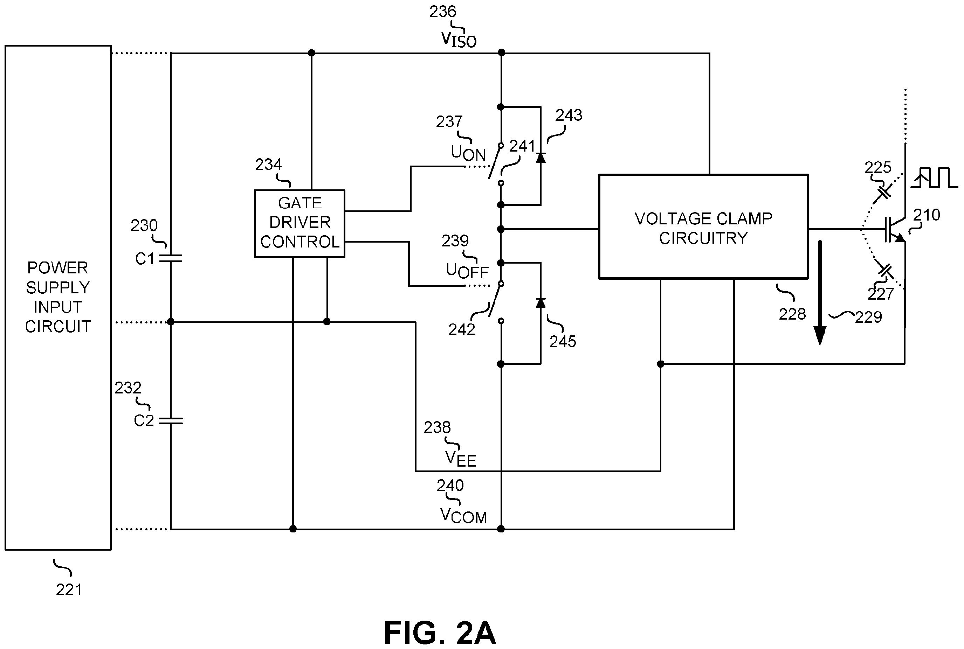

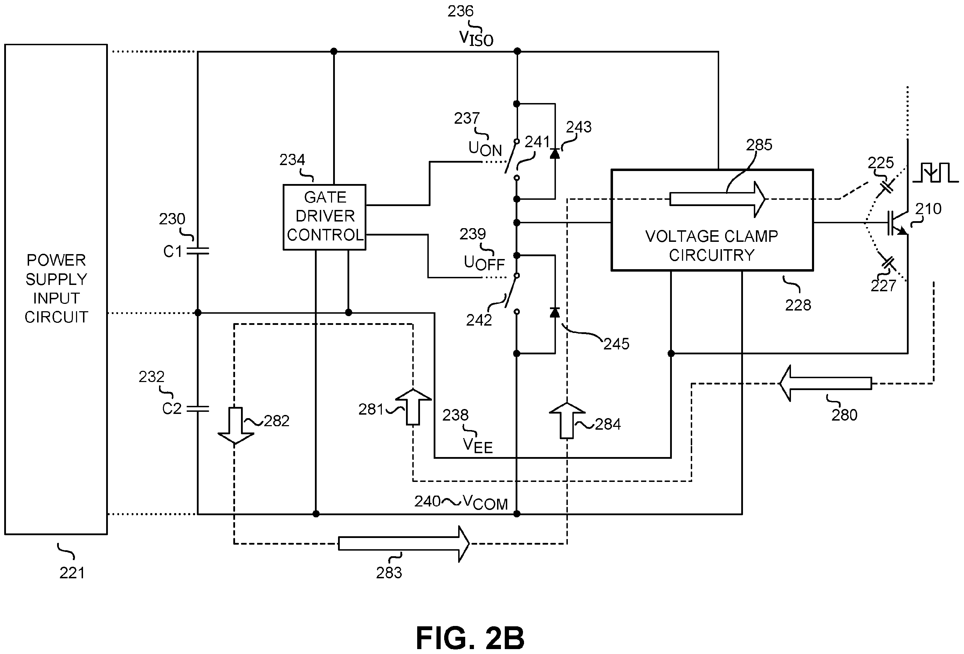

FIG. 2A and 2B are schematic representations of a power switch and command and driver circuitry of a power converter in which a control terminal of the power switch is clamped using reversible voltage clamp circuitry. Power switch 210 can be one or more of power switches 110, 111, 112 and the reversible voltage clamp circuitry can be part of power module 102, 103, 104 (FIG. 1).

The schematic representations each include capacitances 230, 232, a gate driver control 234, switches 241, 242, body diodes 243, 245, voltage clamp circuitry 228, and a power supply input circuit 221. Further, a positive supply rail Vise 236, an emitter voltage node V_{EE} 238, and a common voltage rail V_{COM} 240 are denoted. During normal operation, common voltage rail V_{COM} 240 is negative with respect to emitter voltage node V_{EE} 238. During normal operation and when power switch 210 is actively switching, power supply input circuit 221 generates a potential difference between positive supply rail Vise 236 and a common voltage rail V_{COM} 240 that is suited for allowing gate driver control 234 to drive power switch 210 into and out of conduction.

Capacitance 230 is coupled between positive supply rail Vise 236 and emitter voltage node V_{EE} 238. Capacitance 232 is coupled between emitter voltage node V_{EE} 238 and common voltage rail V_{COM} 240. Capacitances 230, 232 act as decoupling capacitors and help ensure that the potential differences between positive supply rail Vise 236, emitter voltage node V_{EE} 238, and common voltage rail V_{COM} 240 remain relatively stable DC potentials.

In addition to the source of power switch 210, emitter voltage node V_{EE} 238 is also coupled to gate driver control 234 and voltage clamp circuitry 228. The main terminals of switch 241 (and the associated body diode 243) are coupled between positive supply rail Vise 236 and voltage clamp circuitry 228. The control terminal of switch 241 is coupled to be driven by gate driver control 234. This arrangement forms pull-up circuitry that can drive the gate of power switch 210 positive relative to emitter voltage node V_{EE} 238 and drive power switch 210 into conduction.

The main terminals of switch 242 (and the associated body diode 245) are coupled between common voltage rail V_{COM} 240 and voltage clamp circuitry 228. The control terminal of switch 242 is coupled to be driven by gate driver control 234. This arrangement forms pull-down circuitry that can drive the gate of power switch 210 negative relative to emitter voltage node V_{EE} 238 and drive power switch 210 out of conduction.

Voltage clamp circuitry 228 is also coupled to positive supply rail Vise 236, emitter voltage node V_{EE} 238, and common voltage rail V_{COM} 240. Voltage clamp circuitry 228 is coupled to receive the pull-up/pull-down drive signals and allows the gate of power switch 210 to be driven accordingly. However, when power switch 210 is OFF and the gate of power switch 210 is decoupled from the negative voltage that is normally applied to common voltage rail V_{COM} 240, voltage clamp circuitry 228 clamps the potential difference between the gate and emitter of power switch 210 to a level that is below a gate threshold voltage of power switch 210.

As discussed above, in the event that the gate of power switch 210 is decoupled from the negative voltage that is normally applied to common voltage rail V_{COM} 240 when power switch 210 is in the OFF state, other power switches that are coupled in parallel with power switch 210 may actively switch. The voltage across the main terminals of power switch 210 would thus continue to be subject to changes in voltage and current associated with these switching events. For example, the voltage difference between the collector and the emitter of power switch 210 may rise when the other, parallel-coupled power switches are switched out of conduction. Such a rising voltage between the collector and the emitter of power switch 210 can be referred to as a positive switching event. As another example, the voltage difference between the collector and the emitter of power switch 210 may fall when the other, parallel-coupled power switches are switched into conduction. Such a falling voltage between the collector and the emitter of power switch 210 can be referred to as a negative switching event. Such switching events can involve relative high voltages and large currents that are switched over relatively short times. Parasitic current conduction - including current conducted by parasitic capacitance 225 between the collector and gate and by parasitic capacitance 227 between the gate and emitter - can bias the gate of power switch 210 relative to the emitter and drive power switch 210 into conduction. This is especially true if relatively high impedances (e.g., impedances of some ohms) are used between switches 241 and 242 and the gate control terminal of switch 210.

FIG. 2A includes an arrow 229 that schematically represents current flow from the gate to the emitter of power switch 210 through voltage clamp circuitry 228 in the event of a positive switching event. As discussed above, parasitic capacitances 225, 227 can act as a capacitive voltage divider. As other, parallel-coupled power switches are switched out of conduction, the increase in potential difference between the collector and the emitter of power switch 210 can increase the potential difference between the gate and the emitter of power switch 210. However, voltage clamp circuitry 228 clamps the gate of power switch 210 relative to the emitter by allowing the current designated by arrow 229 to flow between the gate and emitter of power switch 210.

FIG. 2B includes a collection of arrows 280, 281, 282, 283, 284, 285 that schematically represent the direction of current flow in the event of a negative switching event. As a result of this current flow, capacitor C2 232 is incrementally charged so that common voltage rail V_{COM} 240-and the gate of power switch 210-becomes negative with respect to emitter voltage node V_{EE} 238. In particular, capacitor C2 232 is charged by the current represented by arrows 280, 281, 282, 283, 284, 285 pulse-by-pulse until the voltage on capacitor C2 232 equilibrates with the voltage on parasitic capacitor 227 with a small difference caused by the voltage drop on body diode 245 during the negative switching event. After equilibration, the voltage across capacitor C2 232 is substantially constant during the negative switching event.

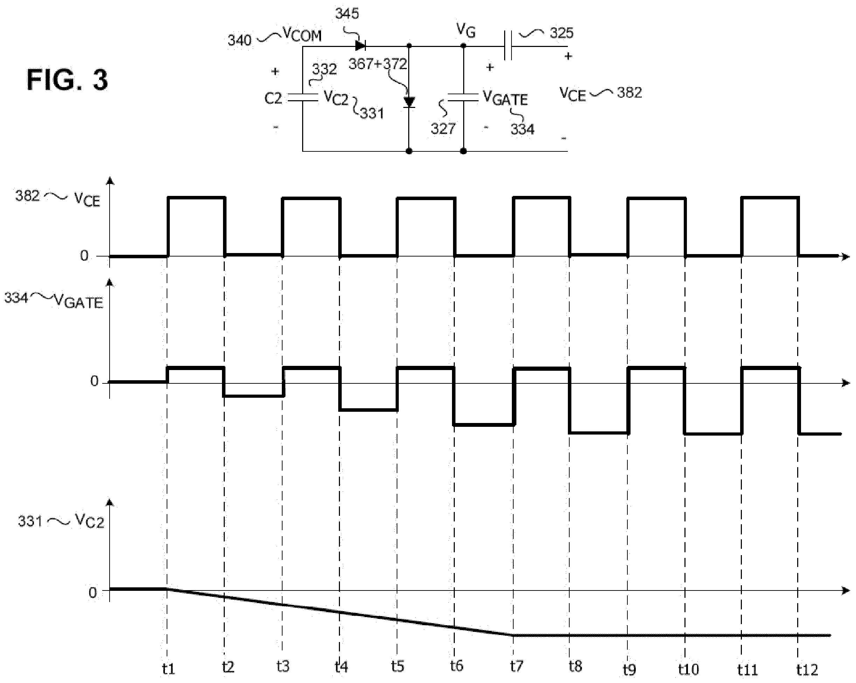

As a result of this charging of capacitor C2 232, the gate-emitter voltage of power switch 210 is shifted to a negative value. Positive voltage swings between the collector and emitter of power switch 210 still cause a transient positive current to flow through parasitic capacitance 227. These transient positive currents continue to increase the gate-to-emitter voltage of the power switch 210. However, with capacitor C2 232 charged so that common voltage rail V_{COM} 240-and the gate of power switch 210-are negative with respect to emitter voltage node V_{EE} 238, these transient increases in the gate-to-emitter voltage of the power switch 210 do not suffice to turn power switch 210 on. Instead, power switch 210 remains in the non-conductive OFF state. Undesired turn ON events of the power switch 210 are avoided. FIG. 3 below illustrates this in further detail.

In example implementations, the collector-to-emitter voltage of power switch 210 will swing in a range of between 0 and 500 to 6500 volts, for example, between 0 and 1000 to 2000 volts or between 0 and 1200 to 1500 volts as one or more other power switches that have their collectors coupled to the collector of power switch 210 are switched. Such swings can cause voltage transients of, e.g., ± between 5-15V, between 1 µs and 3 µs in duration between gate and emitter, at a frequency of between, e.g., 100 Hz and 50 kHz. Under such circumstances and in the presence of the measures described herein, common voltage rail V_{COM} 240-and the gate of power switch 210-can be driven negative with respect to emitter voltage node V_{EE} 238 by, e.g., between 3-7 V in a few milliseconds.

FIG. 3 illustrates a timing diagram and a simplified schematic illustrating how the described measured prevents the turn on of the power switch 210 by incremental charging of capacitor C2 during negative voltage swings across the collector and emitter of the power switch. In particular, V_{CE} 382 is the collector-to-emitter voltage of power switch 210, V_{GATE} 334 is the gate-to-emitter voltage of power switch 310, and V_{C2} 331 is the potential across capacitance C2 332, i.e., the voltage on common voltage rail V_{COM} 240 minus the voltage on emitter voltage node V_{EE} 238.

During negative switching events, capacitor C2 332 is incrementally charged, pulse-by-pulse, so that common voltage rail V_{COM} 240-and the gate of power switch 410-become negative with respect to emitter voltage node V_{EE} 238, as shown in the timing diagrams. As a result of this charging of capacitor C2 332, the gate-emitter voltage of power switch 210 is shifted to a negative value referenced to emitter voltage node V_{EE} 338. Positive voltage swings between the collector and emitter of power switch 210 still cause a transient positive current to flow through parasitic capacitance 427. These transient positive currents continue to increase the gate-to-emitter voltage of the power switch 210 for short periods of time. However, with capacitor C2 332 charged so that common voltage rail V_{COM} 240-and the gate of power switch 210-are negative with respect to emitter voltage node V_{EE} 238, these transient increases in the gate-to-emitter voltage of the power switch 210 do not reach the threshold voltage of power switch 210.

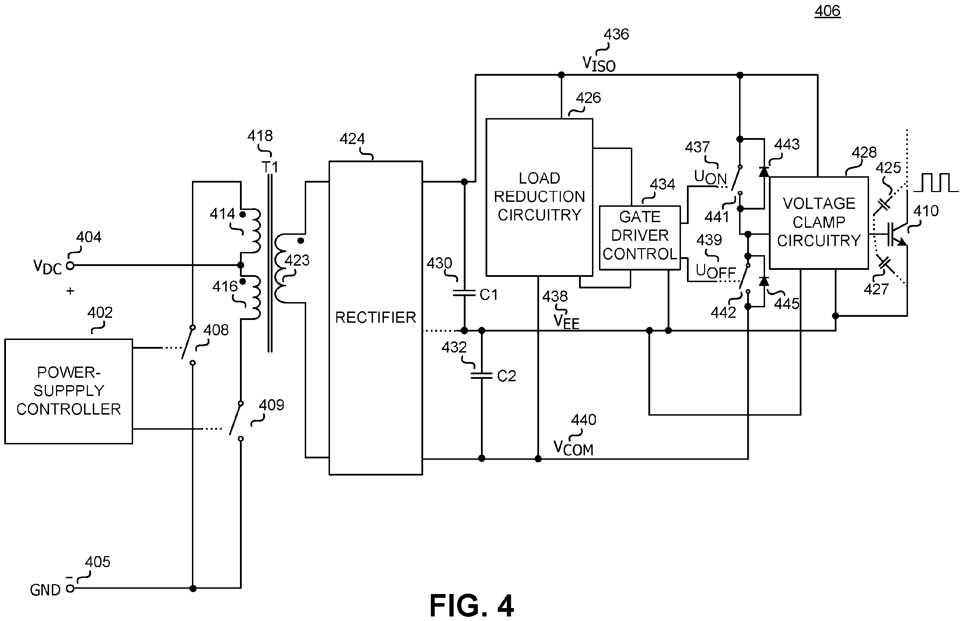

FIG. 4 is a schematic representation of the clamping of a gate driver using voltage clamp circuitry coupled with a load reduction circuit. The power converter includes voltage clamp circuitry 428 and load reduction circuitry 426. Load reduction circuitry 426 cooperates with voltage clamp circuitry 428 both allow power switch 410 to be driven under normal conditions but avoid switching into conduction when the gate is not coupled to a biasing potential. Power switch 410 can be one or more of power switches 110, 111, 112 and the reversible voltage clamp circuitry can be part of power module 102, 103, 104 (FIG. 1).

In the schematic representation, capacitances 430, 432, a gate driver control 434, switches 441, 442, body diodes 443, 445, and voltage clamp circuitry 428, positive supply rail Vise 436, emitter voltage node V_{EE} 438, and common voltage rail V_{COM} 440 are coupled analogously to their counterparts in FIGS. 2A, 2B.

The schematic representation also illustrates components of an example power supply input circuit, namely, a power supply controller 402, a pair of switches 408, 409, an energy transfer element 418, and a rectifier 424. Energy transfer element 418 includes a secondary winding 423 and a pair of primary windings 414, 416. Further, a positive supply rail V_{DC} 404 and a ground or other reference rail GND 405 are denoted.

Primary winding 414 and switch 408 are coupled between positive supply rail V_{DC} 404 and reference rail GND 405. Primary winding 416 and switch 409 are also coupled between positive supply rail VDC 404 and reference rail GND 405, in parallel with primary winding 414 and switch 408. Power supply controller 402 is coupled to switch both switches 408, 409 alternatively.

During active switching of power switch 410, power supply controller 402 alternately drives switches 408, 409 into and out of conduction. This switching induces an ac potential on secondary winding 423. The ac potential is rectified to a dc potential by rectifier 424. The dc potential is supplied across positive supply rail Vise 436 and common voltage rail V_{COM} 440. The dc potential across rails V_{ISO} 436, V_{COM} 440 is used to drive power switch 410. In some cases, the dc potential across rails V_{ISO} 436, V_{COM} 440 will also be used to maintain power switch 410 in an OFF state. Load reduction circuitry 426-which is coupled between positive supply rail Vise 436 and common voltage rail V_{COM} 440-- senses that a suitable dc potential is present therebetween. In response, load reduction circuitry 426 couples gate driver control 434 between positive supply rail Vise 436 and common voltage rail V_{COM} 440.

However, in some circumstances, a suitable dc potential may not arise across rails V_{ISO} 436, V_{COM} 440. For example, controller 402 may be defective. In another example the supply of voltage to positive supply rail V_{DC} 404 may be interrupted. One or more other devices (e.g., rectifier 404, transformer 418, switches 408 or 409, etc.) may be defective. Indeed, using the devices and techniques described herein, the potential across rails V_{ISO} 436, V_{COM} 440 may even be intentionally removed, e.g., to reduce power consumption. Regardless of the reason why a suitable dc potential is not present, load reduction circuitry 426 will sense the absence. In response, load reduction circuitry 426 uncouples gate driver control 434 from between positive supply rail Vise 436 and common voltage rail V_{COM} 440.

This coupling and uncoupling of gate driver control 434 from between positive supply rail Vise 436 and common voltage rail V_{COM} 440 changes the impedance between emitter voltage node V_{EE} 438 and common voltage rail V_{COM} 440. In particular, when gate driver control 434 is coupled between positive supply rail Vise 436 and common voltage rail V_{COM} 440, gate driver control 434 provides a relatively low impedance path between emitter voltage node V_{EE} 438 and common voltage rail V_{COM} 440. The potential difference between voltage node V_{EE} 438 and common voltage rail V_{COM} 440 will tend toward zero. However, when gate driver control 434 is uncoupled, common voltage rail V_{COM} 440 can be maintained at negative voltage with respect to emitter voltage node V_{EE} 438 since common voltage rail V_{COM} 440 and emitter voltage node V_{EE} 438 are isolated from each other by capacitance C2 432.

As discussed above, allowing such a potential difference between emitter voltage node V_{EE} 438 and common voltage rail V_{COM} 440 to be maintained can help prevent parasitic conduction when a suitable dc potential is not present across rails V_{ISO} 436, V_{COM} 440. In particular, if common voltage rail V_{COM} 440 is maintained at negative voltage with respect to emitter voltage node V_{EE} 438, the likelihood that power switch 410 inadvertently switches into conduction is reduced.

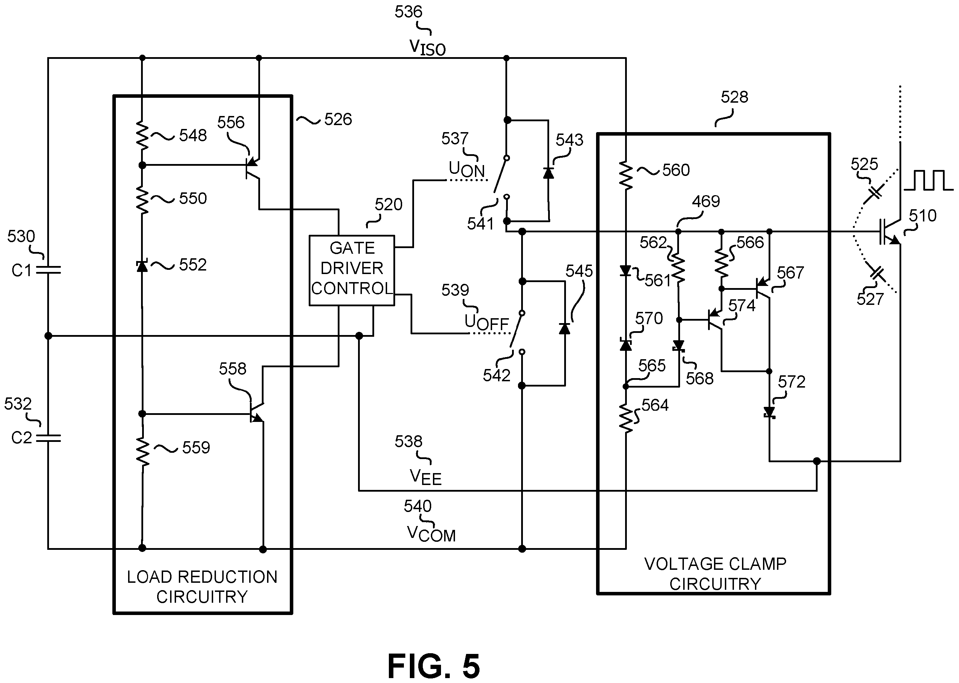

FIG. 5 is a schematic representation of a particular implementation of load reduction circuitry 526 and a voltage clamp circuitry 528 that are suited for implementing voltage clamp circuitry.

In particular, load reduction circuitry 526 includes a pair of transistor switches 556, 558 and a sense and switching line that includes resistances 548, 550, 559 and a diode 552. Transistor switch 556 is coupled between positive supply rail Vise 536 and gate driver control 520. Transistor switch 558 is coupled between common voltage rail V_{COM} 540 and gate driver control 520. Switching of transistor switches 556, 558 couples and decouples gate driver control 520 from these rails.

The sense and switching line that includes resistances 548, 550, 559 and diode 552 senses the potential difference between positive supply rail Vise 536 and common voltage rail V_{COM} 540 and switched transistor switches 556, 558 into and out of conduction in response. In particular, if the potential difference between positive supply rail Vise 536 and common voltage rail V_{COM} 540 is sufficiently high, then transistor switches 556, 558 are switched into conduction and gate driver control 520 is coupled to rail Vise 536 and rail V_{COM} 540. In contrast, if the potential difference between positive supply rail Vise 536 and common voltage rail V_{COM} 540 is insufficiently high, then transistor switches 556, 558 are switched out of conduction and gate driver control 520 is decoupled from rail Vise 536 and rail V_{COM} 540.

By decoupling gate driver control 520 from rail Vise 536 and rail V_{COM} 540 under these circumstances, the current flow path between emitter voltage node V_{EE} 538 and common voltage rail V_{COM} 540 through gate driver control 520 is removed. Furthermore, the current flow path between emitter voltage node V_{EE} 538 and Vise 536 through gate driver control 520 is removed. This allows a potential difference to arise between emitter voltage node V_{EE} 538 and common voltage rail V_{COM} 540, i.e., common voltage rail V_{COM} 540 can become negative with respect to emitter voltage node V_{EE} 538.

Voltage clamp circuit 528 includes resistances 560, 562, 564, 566, diode 561, 568, 570, 572, and PNP bipolar junction transistor switches 574, 567. Diode 561 is a pn junction diode, diode 570, is a Zener diode, diodes 458, 572 are Schottky-diodes.

If the other components of voltage clamp circuit 528 were not present, diode 572 could be connected to the gate of power switch 510 and thereby provide some clamping of the gate-to-emitter voltage of power switch 510. However, this clamping could also undesirably prevent the normal operation of power switch 410, where a positive gate-to-emitter voltage drives and maintains power switch 510 in, e.g., a conductive ON state. Thus, voltage clamp circuit 528 opens and closes the conductive path between the gate and the emitter of power switch 510 using a current controlled switch, namely, the Darlington stage formed by transistors 574, 576. Moreover, it allows charging C2 532 to generate a negative gate voltage in off-state.

Resistances 560, 564 and diodes 561, 570 are coupled in series between the positive supply rail V_{ISO} 536 and common voltage rail V_{COM} 540 to provide a divided voltage on a node 565. Although strictly speaking the voltage on node 565 is determined by the ratio of resistances 560, 564 and the voltage drop across diodes 561, 570, Zener diode 570 is generally primarily responsible for defining the voltage difference between positive supply rail V_{ISO} 536 and common voltage rail V_{COM} 540 that opens and closes the conductive path between the gate of power switch 510. Diode 561 is coupled to prevent a reverse current flow, i.e., current flow gate of power switch over 567, 574, 568 and 570. When a sufficient dc potential is supplied across positive supply rail V_{ISO} 536 and common voltage rail V_{COM} 540, the voltage on node 565 will rise sufficiently high so that transistor switches 574, 567 are not biased into conduction. However, when a sufficient dc potential is not supplied across positive supply rail V_{ISO} 536 and common voltage rail V_{COM} 540, the voltage on node 565 will fall toward the potential of common voltage rail V_{COM} 540. This can bias PNP bipolar junction transistor switches 574, 567 into conduction.

Transistor switches 574, 567 are coupled together as a Darlington pair that, when biased into conduction, conducts current between the gate and emitter of power switch 510 through diode 572. When transistor switches 574, 567 are biased into conduction, the potential difference between the gate and emitter of power switch 510 is clamped at approximately the sum of the diode drop across diode 572 and transistor switches 567, 574. However, when transistor switches 574, 567 are not biased into conduction, there is no current flow through transistor switches 574, 567 and this clamping is removed.

Resistance 562 and diode 568 are coupled in series between the gate of power switch 510 and node 565 to reversibly drive the Darlington pair formed by transistor switches 574, 567 into and out of conduction. In particular, during normal operation when power switch 510 is actively switching and a sufficient dc potential is supplied across positive supply rail V_{ISO} 536 and common voltage rail V_{COM} 540, the base current of transistor switch 574 falls to zero and the Darlington pair formed transistor switches 574, 567 does not conduct current between the gate and emitter of power switch 510.

However, when a sufficient dc potential is not supplied across positive supply rail V_{ISO} 536 and common voltage rail V_{COM} 540, the voltage on node 565 falls toward the potential of common voltage rail V_{COM} 540, a base current can flow though transistor switch 574 and drive the Darlington pair formed by transistor switches 574, 567 into conduction, thus clamping the gate and emitter of power switch 510 to roughly the same voltage as emitter voltage node V_{EE} 538.

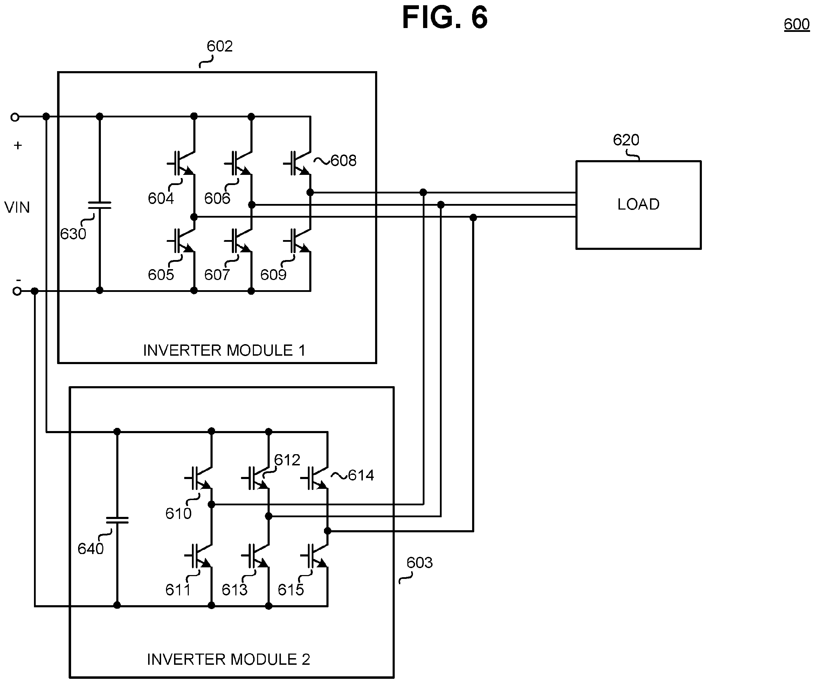

FIG. 6 is a schematic representation of an example system that can use voltage clamp circuitry and load reduction circuitry as described above. In particular, FIG. 6 is a schematic representation of a system 600 that includes two parallel connected 3-phase inverter module 602 and 603. An inverter is a device that can be used to convert direct current to alternating current. By coupling inverter modules 602 and 603 as shown, the magnitude of the alternating current can be suited for high-power applications. For example, system 600 can be, e.g., a part of a photovoltaic power system, a part of a wind mill converter system, a part of an HVDC power transmission system, or a vehicle drive system.

The inverter modules 602 and 603 include one or more decoupling capacitances 630, 640 coupled across the DC input terminals of the module. The one or more decoupling capacitances 630, 640 within the modules can include parallel or series connections of capacitances.

The inverter module 602 also includes three pairs of power switches. In inverter module 602, power switches 604, 605 form the first pair, power switches 606, 607 form the second pair, and power switches 608, 609 form the third pair. The switching of power switches 604, 605, 606, 607, 608, 609 is coordinated to convert direct current to alternating current.

Similarly, the inverter module 603 also includes three pairs of power switches. In inverter module 603, power switches 610, 611 form the first pair, power switches 612, 613 form the second pair, and power switches 614, 615 form the third pair. The switching of power switches 610, 611, 612, 613, 614, 615 is usually synchronized with the switching of power switches 604, 605, 606, 607, 608, 609 of the inverter module 602.

However, at times, the voltage supply to inverter module 602 can be inadvertently or intentionally interrupted. During the interruption, power switches 604, 605, 606, 607, 608, 609 can be clamped using reversible voltage clamp circuitry as described above. Inverter module 603 can further work without the need to physically disconnect inverter module 602 from the load.

The above description of illustrated examples of the present invention, including what is described in the Abstract, are not intended to be exhaustive or to be limitation to the precise forms disclosed. For example, although the gate driver control circuitry provides a path for current flow between emitter voltage node of a power switch and common voltage rail in the illustrated implementations, other components can be used in other implementations. For example, dedicated components can be used to provide such a current flow path.

As another example, although switches 241, 441, 541 have been illustrated as coupling the control terminal of the power switch directly to the positive rail (i.e., without any intermediate components), such coupling is typically mediated by one or more components such as, e.g., a gate resistor.

The scope of protection of the invention is defined solely by the appended claims.

## Claims

1. Power conversion circuitry comprising:
a power switch;
gate driver control circuitry (234, 434, 520) configured to output a drive signal to a control terminal of the power switch (110, 111, 112, 210, 410, 510);
a positive supply rail (236, 436, 536) and a negative supply rail (240, 440, 540) coupled to supply the gate driver control circuitry with a voltage; and
voltage clamp circuitry (228, 428, 528) coupled between a control terminal of the power switch and a second terminal of the power switch, wherein the voltage clamp circuitry is coupled to the positive supply rail and the negative supply rail and is configured to sense that
a) the voltage supplied by the positive supply rail is absent or below a voltage level defined between the positive supply rail and the negative supply and, in response, reversibly clamp the voltage between the control terminal and the second terminal to a clamped voltage level, wherein the clamped voltage level is a level at which the power switch is not biased into conduction, and
b) the voltage supplied by the positive supply rail is above the defined voltage level and, in response, remove the clamping.

2. The power conversion circuitry of claim 1, wherein:
the power switch is an IGBT;
the control terminal is the gate of the IGBT; and
the second terminal is the emitter of the IGBT.

3. The power conversion circuitry of any one of claims 1 to 2, wherein the voltage clamp circuitry comprises a switch coupled to conduct current between the control terminal and the second terminal of the power switch and thereby clamp the voltage between the control terminal and the second terminal of the power switch.

4. The power conversion circuitry of any one of claims 1 to 3, wherein the voltage clamp circuitry further comprises a clamp control circuitry coupled to transition the voltage clamp circuitry between a clamped state in which the voltage clamp circuitry conducts current between the control terminal of the power switch and the second terminal of the power switch and an unclamped state in which the voltage clamp circuitry does not conduct current between the control terminal and the second terminal of the power switch.

5. The power conversion circuitry of any one of claims 1 to 4, wherein the voltage clamp circuitry comprises a variable impedance coupled between the second terminal of the power switch and the control terminal of the power switch, wherein the variable impedance is lower when the voltage clamp circuitry clamps the voltage between the control terminal and the second terminal and is higher when the voltage between the control terminal and the second terminal is unclamped.

6. The power conversion circuitry of claim 5, wherein the variable impedance comprises at least one switch coupled to decouple the gate driver control circuitry from a current conduction path to a negative supply rail of the gate driver control circuitry.

7. The power conversion circuitry of claim 1, wherein:
the power switch (110, 111, 112, 210, 410, 510) has the control terminal and a first terminal and the second terminal, wherein the first terminal is a collector or drain terminal and the second terminal is an emitter or source terminal; and
the power conversion circuitry comprises:
i) a pull-up switch (241, 441, 541) switchable to couple the control terminal of the power switch to the positive supply rail,
ii) a pull-down switch (242, 442, 542) with an internal or external diode, wherein
the pull-down switch is switchable to couple the control terminal of the power switch to the negative supply rail and
the internal or external diode forms an asymmetric conductance (245, 345, 445,545) coupling the control terminal of the power switch to the negative supply rail and the internal or external diode is arranged to not conduct when a potential on the negative supply rail is lower than a potential on the control terminal;
iii) a terminal node (238, 438, 538) coupled to the second terminal of the power switch; and
wherein the gate driver control circuitry (234, 434, 520) is configured to control the pull-up switch and the pull-down switch to output the drive signal to the control terminal of the power switch.

8. The power conversion circuitry of claim 7, wherein the power switch is an IGBT and the second terminal is the emitter of the IGBT.

9. The power conversion circuitry of any one of claims 7 or 8, wherein the voltage clamp circuitry comprises a voltage divider (560, 561, 570, 564) coupled between the positive supply rail and the negative supply rail, wherein the voltage clamp circuitry is configured to sense that the bias between the positive supply rail and the negative supply rail is below the defined voltage level or absent based on a divided voltage of the voltage divider.

10. The power conversion circuitry of any one of claims 7 to 9, wherein the voltage clamp circuitry comprises one or more transistors (567, 574) that, when biased into conduction, are coupled to conduct current between the control terminal and the second terminal, for example, wherein the one or more transistors comprises a Darlington pair of transistors.

11. The power conversion circuitry of any one of claim 7 to 10, wherein the voltage clamp circuitry comprises a zener diode that is coupled with the one or more transistors, wherein the zener diode is coupled to set the clamped voltage level.

12. The power conversion circuitry of any one of claims 7 to 11, further comprising:
a switch (556, 558) coupled between the gate driver control circuitry and one of either the positive supply rail or the negative supply rail; and
sense circuitry coupled to sense that a bias between the positive supply rail and the negative supply rail is unsuitable for supplying power or absent and, in response, reversibly decouple the gate driver control circuitry from the one of either the positive supply rail or the negative supply rail.

13. The power conversion circuitry of claim 12, wherein the sense circuitry comprises a voltage divider coupled between the positive supply rail and the negative supply rail, wherein a divided voltage of the voltage divider is coupled to a control terminal of the switches (556, 558) of load reduction circuitry.

14. The power conversion circuitry of claim 13, wherein the voltage divider comprises resistors (548, 550, 559) and a Zener diode (552), wherein the Zener diode (552) defines the transition point of coupling and decoupling the load reduction circuitry.

15. An inverter or DC-DC converter comprising:
circuitry for power conversion according to any one of claims 1-14.

## Patentansprüche

1. Schaltungsanordnung zur Leistungsumwandlung, umfassend:
einen Leistungsschalter;
Gate-Treiber-Steuerschaltungsanordnung (234, 434, 520), die dafür ausgelegt ist, ein Treibersignal an einen Steueranschluss des Leistungsschalters (110, 111, 112, 210, 410, 510) auszugeben;
eine positive Versorgungsschiene (236, 436, 536) und eine negative Versorgungsschiene (240, 440, 540), die so gekoppelt sind, dass sie die Gate-Treiber-Steuerschaltungsanordnung mit einer Spannung versorgen; und
eine Spannungsklemmschaltungsanordnung (228, 428, 528), die zwischen einen Steueranschluss des Leistungsschalters und einen zweiten Anschluss des Leistungsschalters gekoppelt ist, wobei die Spannungsklemmschaltungsanordnung mit der positiven Versorgungsschiene und der negativen Versorgungsschiene gekoppelt ist und dafür ausgelegt ist, zu erfassen, dass:
a) die von der positiven Versorgungsschiene gelieferte Spannung nicht vorhanden ist oder unter einem Spannungspegel liegt, der zwischen der positiven Versorgungsschiene und der negativen Versorgung definiert ist, und als Reaktion darauf die Spannung zwischen dem Steueranschluss und dem zweiten Anschluss reversibel auf einen geklemmten Spannungspegel zu klemmen, wobei der geklemmte Spannungspegel ein Pegel ist, bei dem der Leistungsschalter nicht in den leitenden Zustand vorgespannt ist, und
b) die von der positiven Versorgungsschiene zugeführte Spannung über dem definierten Spannungspegel liegt, und als Reaktion darauf die Klemmung aufzuheben.

2. Schaltungsanordnung zur Leistungsumwandlung nach Anspruch 1, wobei:
der Leistungsschalter ein IGBT ist;
der Steueranschluss das Gate des IGBT ist; und
der zweite Anschluss der Emitter des IGBT ist.

3. Schaltungsanordnung zur Leistungsumwandlung nach einem der Ansprüche 1 bis 2, wobei die Spannungsklemmschaltungsanordnung einen Schalter umfasst, der so gekoppelt ist, dass er Strom zwischen dem Steueranschluss und dem zweiten Anschluss des Leistungsschalters leitet und dadurch die Spannung zwischen dem Steueranschluss und dem zweiten Anschluss des Leistungsschalters klemmt.

4. Schaltungsanordnung zur Leistungsumwandlung nach einem der Ansprüche 1 bis 3, wobei die Spannungsklemmschaltungsanordnung ferner eine Klemmsteuerschaltungsanordnung umfasst, die so gekoppelt ist, dass sie die Spannungsklemmschaltungsanordnung zwischen einem geklemmten Zustand, in dem die Spannungsklemmschaltungsanordnung Strom zwischen dem Steueranschluss des Leistungsschalters und dem zweiten Anschluss des Leistungsschalters leitet, und einem ungeklemmten Zustand, in dem die Spannungsklemmschaltungsanordnung keinen Strom zwischen dem Steueranschluss und dem zweiten Anschluss des Leistungsschalters leitet, umschaltet.

5. Schaltungsanordnung zur Leistungsumwandlung nach einem der Ansprüche 1 bis 4, wobei die Spannungsklemmschaltungsanordnung eine variable Impedanz umfasst, die zwischen dem zweiten Anschluss des Leistungsschalters und dem Steueranschluss des Leistungsschalters gekoppelt ist, wobei die variable Impedanz niedriger ist, wenn die Spannungsklemmschaltungsanordnung die Spannung zwischen dem Steueranschluss und dem zweiten Anschluss klemmt, und höher ist, wenn die Spannung zwischen dem Steueranschluss und dem zweiten Anschluss nicht geklemmt ist.

6. Schaltungsanordnung zur Leistungsumwandlung nach Anspruch 5, wobei die variable Impedanz mindestens einen Schalter umfasst, der so gekoppelt ist, dass er die Gate-Treiber-Steuerschaltungsanordnung von einem Stromleitungspfad zu einer negativen Versorgungsschiene der Gate-Treiber-Steuerschaltungsanordnung entkoppelt.

7. Schaltungsanordnung zur Leistungsumwandlung nach Anspruch 1, wobei:
der Leistungsschalter (110, 111, 112, 210, 410, 510) den Steueranschluss und einen ersten Anschluss und den zweiten Anschluss aufweist, wobei der erste Anschluss ein Kollektor- oder Drain-Anschluss und der zweite Anschluss ein Emitter- oder Source-Anschluss ist; und
die Schaltungsanordnung zur Leistungsumwandlung umfasst:
i) einen Pull-up-Schalter (241, 441, 541), der dazu schaltbar ist, den Steueranschluss des Leistungsschalters mit der positiven Versorgungsschiene zu verbinden,
ii) einen Pull-down-Schalter (242, 442, 542) mit einer internen oder externen Diode, wobei
der Pull-down-Schalter dazu schaltbar ist, den Steueranschluss des Leistungsschalters mit der negativen Versorgungsschiene zu koppeln, und
die interne oder externe Diode einen asymmetrischen Leitwert (245, 345, 445, 545) bildet, der den Steueranschluss des Leistungsschalters mit der negativen Versorgungsschiene koppelt, und die interne oder externe Diode so eingerichtet ist, dass sie nicht leitet, wenn ein Potenzial auf der negativen Versorgungsschiene niedriger ist als ein Potenzial auf dem Steueranschluss;
iii) einen Anschlussknoten (238, 438, 538), der mit dem zweiten Anschluss des Leistungsschalters gekoppelt ist; und
wobei die Gate-Treiber-Steuerschaltungsanordnung (234, 434, 520) dafür ausgelegt ist, den Pull-up-Schalter und den Pull-down-Schalter zum Ausgeben des Treibersignals an den Steueranschluss des Leistungsschalters zu steuern.

8. Schaltungsanordnung zur Leistungsumwandlung nach Anspruch 7, wobei der Leistungsschalter ein IGBT ist und der zweite Anschluss der Emitter des IGBT ist.

9. Schaltungsanordnung zur Leistungsumwandlung nach einem der Ansprüche 7 oder 8, wobei die Spannungsklemmschaltungsanordnung einen Spannungsteiler (560, 561, 570, 564) umfasst, der zwischen die positive Versorgungsschiene und die negative Versorgungsschiene gekoppelt ist, wobei die Spannungsklemmschaltungsanordnung dafür ausgelegt ist, zu erfassen, dass die Vorspannung zwischen der positiven Versorgungsschiene und der negativen Versorgungsschiene unter dem definierten Spannungspegel liegt oder nicht vorhanden ist, basierend auf einer geteilten Spannung des Spannungsteilers.

10. Schaltungsanordnung zur Leistungsumwandlung nach einem der Ansprüche 7 bis 9, wobei die Spannungsklemmschaltungsanordnung einen oder mehrere Transistoren (567, 574) umfasst, die, wenn sie in den leitenden Zustand vorgespannt sind, so gekoppelt sind, dass sie Strom zwischen dem Steueranschluss und dem zweiten Anschluss leiten, beispielsweise wobei der eine oder die mehreren Transistoren ein Darlington-Transistorpaar umfasst.

11. Schaltungsanordnung zur Leistungsumwandlung nach einem der Ansprüche 7 bis 10, wobei die Spannungsklemmschaltungsanordnung eine Zenerdiode umfasst, die mit dem einen oder den mehreren Transistoren gekoppelt ist, wobei die Zenerdiode so gekoppelt ist, dass sie den geklemmten Spannungspegel einstellt.

12. Schaltungsanordnung zur Leistungsumwandlung nach einem der Ansprüche 7 bis 11, ferner umfassend:
einen Schalter (556, 558), der zwischen die Gate-Treiber-Steuerschaltungsanordnung und eines von entweder der positiven Versorgungsschiene oder der negativen Versorgungsschiene gekoppelt ist; und
eine Erfassungsschaltungsanordnung, die so gekoppelt ist, dass sie erfasst, dass eine Vorspannung zwischen der positiven Versorgungsschiene und
der negativen Versorgungsschiene für die Stromversorgung ungeeignet oder nicht vorhanden ist, und als Reaktion darauf die Gate-Treiber-Steuerschaltungsanordnung vom einen von entweder der positiven Versorgungsschiene oder der negativen Versorgungsschiene reversibel entkoppelt.

13. Schaltungsanordnung zur Leistungsumwandlung nach Anspruch 12, wobei die Erfassungsschaltung einen Spannungsteiler umfasst, der zwischen die positive Versorgungsschiene und die negative Versorgungsschiene gekoppelt ist, wobei eine geteilte Spannung des Spannungsteilers mit einem Steueranschluss der Schalter (556, 558) einer Lastreduktionsschaltungsanordnung gekoppelt ist.

14. Schaltungsanordnung zur Leistungsumwandlung nach Anspruch 13, wobei der Spannungsteiler Widerstände (548, 550, 559) und eine Zenerdiode (552) umfasst, wobei die Zenerdiode (552) den Übergangspunkt der Kopplung und der Entkopplung der Lastreduktionsschaltungsanordnung definiert.

15. Wechselrichter oder Gleichspannungswandler, umfassend:
Schaltungsanordnung zur Leistungsumwandlung nach einem der Ansprüche 1 bis 14.

## Revendications

1. Circuit de conversion de puissance comprenant :
un commutateur de puissance ;
un circuit de commande de moyen de pilotage de grille (234, 434, 520) configuré pour émettre en sortie un signal de pilotage sur une borne de commande du commutateur de puissance (110, 111, 112, 210, 410, 510) ;
un rail d'alimentation positif (236, 436, 536) et un rail d'alimentation négatif (240, 440, 540) couplés pour alimenter le circuit de commande de moyen de pilotage de grille avec une tension ; et
un circuit de limitation de tension (228, 428, 528) couplé entre une borne de commande du commutateur de puissance et une seconde borne du commutateur de puissance, dans lequel le circuit de limitation de tension est couplé au rail d'alimentation positif et au rail d'alimentation négatif et
est configuré pour détecter que
a) la tension alimentée par le rail d'alimentation positif est absente ou en-deçà d'un niveau de tension défini entre le rail d'alimentation positif et le rail d'alimentation négatif et, en réponse, pour limiter de façon réversible la tension entre la borne de commande et la seconde borne à un niveau de tension limité, dans lequel le niveau de tension limité est un niveau auquel le commutateur de puissance n'est pas polarisé en conduction, et
b) la tension alimentée par le rail d'alimentation positif est au-delà du niveau de tension défini et, en réponse, pour supprimer la limitation.

2. Circuit de conversion de puissance selon la revendication 1, dans lequel :
le commutateur de puissance est un IGBT ;
la borne de commande est la grille de l'IGBT ; et
la seconde borne est l'émetteur de l'IGBT.

3. Circuit de conversion de puissance selon l'une quelconque des revendications 1 et 2, dans lequel le circuit de limitation de tension comprend un commutateur couplé pour conduire le courant entre la borne de commande et la seconde borne du commutateur de puissance et pour ainsi limiter la tension entre la borne de commande et la seconde borne du commutateur de puissance.

4. Circuit de conversion de puissance selon l'une quelconque des revendications 1 à 3, dans lequel le circuit de limitation de tension comprend en outre un circuit de commande de limitation couplé pour faire passer le circuit de limitation de tension entre un état limité dans lequel le circuit de limitation de tension conduit le courant entre la borne de commande du commutateur de puissance et la seconde borne du commutateur de puissance et un état non limité dans lequel le circuit de limitation de tension ne conduit pas le courant entre la borne de commande et la seconde borne du commutateur de puissance.

5. Circuit de conversion de puissance selon l'une quelconque des revendications 1 à 4, dans lequel le circuit de limitation de tension comprend une impédance variable couplée entre la seconde borne du commutateur de puissance et la borne de commande du commutateur de puissance, dans lequel l'impédance variable est plus petite lorsque le circuit de limitation de tension limite la tension entre la borne de commande et la seconde borne et est plus grande lorsque la tension entre la borne de commande et la seconde borne n'est pas limitée.

6. Circuit de conversion de puissance selon la revendication 5, dans lequel l'impédance variable comprend au moins un commutateur couplé pour découpler le circuit de commande de moyen de pilotage de grille depuis une voie de conduction de courant jusqu'à un rail d'alimentation négatif du circuit de commande de moyen de pilotage de grille.

7. Circuit de conversion de puissance selon la revendication 1, dans lequel :
le commutateur de puissance (110, 111, 112, 210, 410, 510) comporte la borne de commande et une première borne et la seconde borne, dans lequel la première borne est une borne de collecteur ou de drain et la seconde borne est une borne d'émetteur ou de source ; et
le circuit de conversion de puissance comprend :
i) un commutateur d'excursion haute (241, 441, 541) pouvant être commuté pour coupler la borne de commande du commutateur de puissance au rail d'alimentation positif,
ii) un commutateur d'excursion basse (242, 442, 542) avec une diode interne ou externe, dans lequel
le commutateur d'excursion basse peut être commuté pour coupler la borne de commande du commutateur de puissance au rail d'alimentation négatif, et
la diode interne ou externe forme une conductance asymétrique (245, 345, 445, 545) qui couple la borne de commande du commutateur de puissance au rail d'alimentation négatif et la diode interne ou externe est agencée de manière à ne pas conduire lorsqu'un potentiel sur le rail d'alimentation négatif est inférieur à un potentiel sur la borne de commande ;
iii) un noeud de borne (238, 438, 538) couplé à la seconde borne du commutateur de puissance ; et
dans lequel le circuit de commande de moyen de pilotage de grille (234, 434, 520) est configuré pour commander le commutateur d'excursion haute et le commutateur d'excursion basse pour émettre en sortie le signal de pilotage sur la borne de commande du commutateur de puissance.

8. Circuit de conversion de puissance selon la revendication 7, dans lequel le commutateur de puissance est un IGBT et la seconde borne est l'émetteur de l'IGBT.

9. Circuit de conversion de puissance selon l'une quelconque des revendications 7 ou 8, dans lequel le circuit de limitation de tension comprend un diviseur de tension (560, 561, 570, 564) couplé entre le rail d'alimentation positif et le rail d'alimentation négatif, dans lequel le circuit de limitation de tension est configuré pour détecter que la polarisation entre le rail d'alimentation positif et le rail d'alimentation négatif est en-deçà du niveau de tension défini ou est absente sur la base d'une tension divisée du diviseur de tension.

10. Circuit de conversion de puissance selon l'une quelconque des revendications 7 à 9, dans lequel le circuit de limitation de tension comprend un ou plusieurs transistors (567, 574) qui, lorsqu'ils sont polarisés en conduction, sont couplés pour conduire le courant entre la borne de commande et la seconde borne, par exemple dans lequel les un ou plusieurs transistors comprennent une paire de transistors Darlington.

11. Circuit de conversion de puissance selon l'une quelconque des revendications 7 à 10, dans lequel le circuit de limitation de tension comprend une diode Zener qui est couplée aux un ou plusieurs transistors, dans lequel la diode Zener est couplée pour définir le niveau de tension limité.

12. Circuit de conversion de puissance selon l'une quelconque des revendications 7 à 11, comprenant en outre :
un commutateur (556, 558) couplé entre le circuit de commande de moyen de pilotage de grille et soit le rail d'alimentation positif, soit le rail d'alimentation négatif ; et
un circuit de détection couplé pour détecter qu'une polarisation entre le rail d'alimentation positif et le rail d'alimentation négatif est inappropriée pour alimenter de la puissance ou est absente et, en réponse, pour découpler de façon réversible le circuit de commande de moyen de pilotage de grille vis-à-vis de celui considéré du rail d'alimentation positif ou du rail d'alimentation négatif.

13. Circuit de conversion de puissance selon la revendication 12, dans lequel le circuit de détection comprend un diviseur de tension couplé entre le rail d'alimentation positif et le rail d'alimentation négatif, dans lequel une tension divisée du diviseur de tension est couplée à une borne de commande des commutateurs (556, 558) d'un circuit de réduction de charge.

14. Circuit de conversion de puissance selon la revendication 13, dans lequel le diviseur de tension comprend des résistances (548, 550, 559) et une diode Zener (552), dans lequel la diode Zener (552) définit le point de transition du couplage et du découplage du circuit de réduction de charge.

15. Inverseur ou convertisseur DC-DC comprenant :
un circuit pour la conversion de puissance selon l'une quelconque des revendications 1 à 14.
